(19) **Europäisches Patentamt / European Patent Office / Office européen des brevets**

(11) **EP 3 870 983 B1**

(12) **EUROPÄISCHE PATENTSCHRIFT**

(45) Veröffentlichungstag und Bekanntmachung des Hinweises auf die Patenterteilung:
**20.12.2023 Patentblatt 2023/51**

(21) Anmeldenummer: **19797202.9**

(22) Anmeldetag: **24.10.2019**

(51) Internationale Patentklassifikation (IPC):
**G01R 31/08** (2020.01)   **G01R 31/11** (2006.01)
**G01R 31/12** (2020.01)   **G01R 31/14** (2006.01)

(52) Gemeinsame Patentklassifikation (CPC):
**G01R 31/11; G01R 31/083; G01R 31/1272; G01R 31/14**

(86) Internationale Anmeldenummer:
**PCT/EP2019/079037**

(87) Internationale Veröffentlichungsnummer:
**WO 2020/084058 (30.04.2020 Gazette 2020/18)**

(54) **ZUSTANDSANALYSE EINES ELEKTRISCHEN BETRIEBSMITTELS**

STATE ANALYSIS OF AN ELECTRICAL OPERATING RESOURCE

ANALYSE D'ÉTAT D'UN MATÉRIEL ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.10.2018 DE 102018126743**

(43) Veröffentlichungstag der Anmeldung:
**01.09.2021 Patentblatt 2021/35**

(73) Patentinhaber: **Maschinenfabrik Reinhausen GmbH**
**93059 Regensburg (DE)**

(72) Erfinder: **WINKELMANN, Erik**
**01099 Dresden (DE)**

(56) Entgegenhaltungen:
**CN-A- 102 565 634      CN-A- 106 160 944**
**CN-A- 107 656 226      DE-A1- 10 005 540**
**DE-B3-102017 116 613   US-A- 4 887 041**
**US-A1- 2011 125 701    US-B2- 6 420 879**

**Beschreibung**

Die Erfindung betrifft ein Verfahren zur Zustandsanalyse eines elektrischen Betriebsmittels und eine Prüfvorrichtung zur Zustandsanalyse eines elektrischen Betriebsmittels.

Als Teilentladung, TE, wird eine örtlich beschränkte elektrische Entladung bezeichnet, welche eine Isolierung zwischen Leitern nur teilweise überbrückt und welche angrenzend an einem Leiter auftreten kann, aber nicht muss. Teilentladungen können auf Fehlerquellen, beispielsweise auf Fehlstellen oder Inhomogenitäten in der elektrischen Isolierung, zurückzuführen sein. Teilentladungen tragen zur Alterung der elektrischen Isolierung bei und wirken sich daher nachteilig auf deren dielektrische Qualität, insbesondere Durchschlagsfestigkeit, aus. Um die dielektrische Qualität von elektrischen Betriebsmitteln zu gewährleisten, werden Teilentladungsmessungen durchgeführt, um das Vorliegen von Teilentladungen zu prüfen und gegebenenfalls deren spezifische Eigenschaften zu bestimmen.

Naturgemäß muss ein Signal, das durch eine TE als Antwort auf eine Prüfspannung erzeugt wird einen gewissen Übertragungsweg zwischen Ort der TE und Messort passieren. Abhängig von der Verteilung der induktiven, kapazitiven und resistiven Elemente des Betriebsmittels (Kabel, Transformator etc.) wird der ursprüngliche TE-Impuls gedämpft und verformt. Am Messpunkt kann in der Regel nur ein Bruchteil der an der Fehlstelle umgesetzten Entladungsenergie gemessen werden. Man spricht deshalb von der sogenannten scheinbaren Ladung. Daher werden mit bekannten Messverfahren nur geringe Empfindlichkeiten erreicht. Je größer eine Entfernung zwischen Ort der TE und Messort ist, desto größer ist der Fehler bei der Bestimmung der scheinbaren Ladung. Bei der Qualitätssicherung und -überwachung von Betriebsmitteln werden in der Regel TE-Werte definiert, die nicht überschritten werden dürfen. Diese Definition bezieht sich dabei auf die am Messpunkt messbare scheinbare Ladung, die wiederum nur ein Bruchteil der eigentlichen Entladungsenergie ist. Eine Qualitätssicherung des Betriebsmittels ist dadurch nur eingeschränkt möglich.

Um einen möglichen Fehler in dem Betriebsmittel zu orten kann das Verfahren der Zeitbereichsreflektometrie eingesetzt werden. Dabei entspricht der Zeitversatz zwischen eingespeistem Prüfpuls und gemessener Reflektion dem doppelten Weg zum Fehlerort. Messtechnisch wird dies durch Signaldämpfung und -dispersion erheblich erschwert, da die Ortung nach diesem Verfahren nur bei ausreichender Signalamplitude möglich ist. Außerdem setzt das Verfahren eine Reflektion am Fehlerort voraus, was aufgrund der Wellenimpedanz am Fehlerort nicht immer der Fall ist. Im Netzbetrieb von bestimmten Betriebsmitteln, beispielsweise gasisolierten Schaltanlagen, GIS, oder gasisolierten Leitungen, GIL, ist die Fehlerortung in der oben beschriebenen Weise oft nicht möglich, da eine Vielzahl von Entladungen die eventuell vorhandene Reflektion überdeckt oder die Amplitude der zu ortenden Entladung zu klein ist um nach der Reflektion noch gemessen werden zu können.

In der Druckschrift DE 10 2017 116613 B3 wird bei einem Verfahren zur Messung von Teilentladungsimpulsen eines geschirmten Kabels ein Koppelkondensator mit einer ersten Anschlussstelle der Seele des Kabels verbunden. Eine erste, eine zweite und eine dritte Koppeleinheit werden bereitgestellt. Ein Eingang der ersten Koppeleinheit wird mit dem Koppelkondensator verbunden. Der Eingang der zweiten Koppeleinheit wird mit einer ersten Anschlussstelle des Schirms des Kabels und der Eingang der dritten Koppeleinheit mit einer zweiten Anschlussstelle des Schirms verbunden. An der ersten Anschlussstelle der Seele wird eine Prüfspannung bereitgestellt. In Abhängigkeit von den Messsignalen wird wenigstens ein Kennwert für eine scheinbare Ladung des Teilentladungspulses bestimmt.

Es ist daher eine Aufgabe der vorliegenden Erfindung, ein verbessertes Konzept zur TE Messung eines elektrischen Betriebsmittels anzugeben, welches eine höhere Genauigkeit der TE Analyse ermöglicht.

Diese Aufgabe wird durch den jeweiligen Gegenstand der unabhängigen Ansprüche gelöst. Weitere Ausführungsformen sind Gegenstand der abhängigen Ansprüche.

Das verbesserte Konzept beruht auf der Idee, aus einem Messsignal, welches insbesondere in Antwort auf eine angelegte Prüfspannung erfasst wird, den Einfluss des Übertragungsweges auf das Signal zu identifizieren. Dieser Einfluss wird durch Übertragungsparameter beschrieben, welche für die Teilentladung beziehungsweise die Fehlerquelle oder Fehlerquellen charakteristisch sind. Daher lassen die Übertragungsparameter Rückschlüsse auf Kenngrößen der Teilentladung zu.

Gemäß dem verbesserten Konzept wird ein Verfahren zur Zustandsanalyse eines elektrischen Betriebsmittels angegeben. Gemäß dem Verfahren wird eine Prüfspannung an das Betriebsmittel angelegt, beispielsweise in das Betriebsmittel eingeprägt, insbesondere an einer Einprägestelle des Betriebsmittels. Daraufhin wird ein Messsignal an einer Anschlussstelle des Betriebsmittels erfasst. Abhängig von dem Messsignal werden Übertragungsparameter ermittelt, welche eine Signalübertragung von einem Ort einer Teilentladung in dem Betriebsmittel zu der Anschlussstelle charakterisieren. In Abhängigkeit von den Übertragungsparametern wird wenigstens eine Kenngröße der Teilentladung bestimmt.

Das Messsignal kann als Antwort auf die Prüfspannung durch die Teilentladung verstanden werden. Als Antwort auf die Prüfspannung können auch mehrere Teilentladungen beispielsweise an verschiedenen Orten des Betriebsmittels gemeinsam zu dem Messsignal führen. Dies ist von der Formulierung "Ort der Teilentladung" umfasst und gegebenenfalls als "Orte der Teilentladungen" oder entsprechend zu verstehen.

Gemäß wenigstens einer Ausführungsform des Verfahrens beinhaltet das Ermitteln der Übertragungsparameter eine Diskretisierung und/oder Digitalisierung des Messsignals, wodurch ein diskretes Messsignal erzeugt wird.

Gemäß wenigstens einer Ausführungsform des Verfahrens stellen die Übertragungsparameter Parameter einer Transferfunktion oder Übertragungsfunktion dar, welche die Signalübertragung von dem Ort einer Teilentladung zu der Anschlussstelle charakterisieren. Das Messsignal oder das diskrete Messsignal kann dabei als Abbildung eines Eingangssignals am Ort der Teilentladung, oder im Falle mehrerer Teilentladungen an einem scheinbaren Teilentladungsort, verstanden werden, wobei die Übertragungsfunktion als Abbildungsoperator fungiert. Die Übertragungsfunktion kann hier und im Folgenden immer auch eine Approximation einer exakten Übertragungsfunktion darstellen.

Die Prüfspannung ist insbesondere eine Wechselspannung, beispielsweise mit einer Frequenz im Bereich 0-500 Hz. Jedoch kann in verschiedenen Ausführungsformen alternativ Gleichspannung als Prüfspannung verwendet werden. Die Prüfspannung wird insbesondere durch eine Hochspannungsquelle bereitgestellt, welche direkt oder indirekt, insbesondere über wenigstens eine Sperrimpedanz und/oder über ein Eingangsfilter, mit der Einprägestelle verbunden wird. Die Sperrimpedanz und/oder das Eingangsfilter können dazu dienen, die Hochspannungsquelle vom restlichen Prüfaufbau zu entkoppeln.

Gemäß der Erfindung werden die Übertragungsparameter mittels eines Verfahrens zur linearen prädiktiven Kodierung (englisch: "linear predictive coding"), LPC, oder Teilen eines Verfahrens zur LPC, ermittelt. LPC Verfahren werden derzeit in der Audiosignal- und Sprachverarbeitung verwendet. Dabei wird ein Signalwert zu einem bestimmten Zeitpunkt aus einer Linearkombination von Signalwerten zu vorherigen diskreten Zeitpunkten bestimmt und somit gewissermaßen vorhergesagt.

Gemäß wenigstens einer Ausführungsform beinhaltet das Ermitteln der Übertragungsparameter, insbesondere das Verfahren zur LPC, das Ermitteln von Filterkoeffizienten eines virtuellen Filters, wobei das Filter die Signalübertragung näherungsweise nachbildet.

Als virtuell wird das Filter hier bezeichnet, da es keine physische Entsprechung im Sinne eines dedizierten Filterbauteils hat, sondern effektiv durch das Betriebsmittel, den Messkreis und gegebenenfalls die Fehlerquelle oder Fehlerquellen gebildet wird.

Beispielsweise wird das Filter gemäß LPC durch eine Rekursionsgleichung beschrieben, beispielsweise wie folgt

$$y(k)=e(k)+ \sum_{i=1}^{N} a_i \cdot y(k-i) \ . \tag{1}$$

Dabei ist k eine diskrete Zeitvariable, also eine natürliche Zahl größer Null, y(k) ist der Wert des diskreten Messsignals zum diskreten Zeitpunkt k und N ist eine Ordnung der Approximation. Dabei wird y(k-i) = 0 definiert falls (k-i) kleiner oder gleich Null ist. Die $a_k$ sind dabei die sogenannten linearen Prädiktoren der N-ten Ordnung und e(k) ist ein Vorhersagefehler. Gemäß wenigstens einer Ausführrungsform stellen die Prädiktoren $a_k$ die Übertragungsparameter dar.

Da die Werte des diskreten Messsignals bekannt sind, können die Übertragungsparameter bestimmt werden, indem der gesamte quadratische Fehler minimiert wird. Der gesamte quadratische Fehler ist gegeben durch qE gemäß der Gleichung

$$qE = \sum_{k=1}^{N} e^2(k)= \sum_{k=1}^{N} ( y(k) - \sum_{i=1}^{N} a_i \cdot y(k-i) \ )^2 \ . \tag{2}$$

Dazu kann der gesamte quadratische Fehler der $a_i$ differenziert werden, das jeweilige Ergebnis mit Null gleichgesetzt werden und das resultierende Gleichungssystem aus N linearen Gleichungen gelöst werden.

Gemäß wenigstens einer Ausführungsform ist das Betriebsmittel homogen aufgebaut, insbesondere sind Widerstandselemente, induktive und/oder kapazitive Elemente des Betriebsmittels homogen verteilt. Bei dem homogen aufgebauten Betriebsmittel kann es sich beispielsweise um ein Kabel, insbesondere ein geschirmtes Kabel, zum Beispiel ein geschirmtes Hochspannungskabel, eine GIS oder eine GIL handeln.

Gemäß wenigstens einer Ausführungsform ist das Betriebsmittel inhomogen aufgebaut insbesondere sind Widerstandselemente, induktive und/oder kapazitive Elemente des Betriebsmittels inhomogen verteilt. Bei dem inhomogen aufgebauten Betriebsmittel kann es sich beispielsweise um einen Leistungstransformator, einen Stufenschalter oder eine andere Komponente eines Leistungstransformators handeln. Es kann sich bei dem inhomogen aufgebauten Betriebsmittel auch um einen Leistungsschalter, einen Trenner, einen Trennschalter für den Einsatz in GIS oder luftisolierten Schaltanlagen, einen Messwandler, einen Überspannungsableiter handeln.

Gemäß wenigstens einer Ausführungsform beinhaltet die wenigstens eine Kenngröße einer oder mehrerer Fehlerquellen, aus denen die Teilentladung resultiert. Dies kann sowohl für homogen aufgebaute als auch für inhomogen aufgebaute Betriebsmittel vorteilhaft sein.

Insbesondere kann eine solche Ausführungsform bei DC Anwendungen oder Anwendungen zur kontinuierlichen Überwachung beziehungsweise Monitoring des Betriebsmittels von Vorteil sein.

Gemäß wenigstens einer Ausführungsform beinhaltet die wenigstens eine Kenngröße der einen oder mehreren Fehlerquellen eine Anzahl der Fehlerquellen oder einen relativen Beitrag einer der Fehlerquellen zu der Teilentladung, insbesondere zu einem gesamten Ladungswert der Teilungsladung.

Gemäß wenigstens einer Ausführungsform wird die wenigstens eine Kenngröße der Fehlerquellen zur Identifizierung eines Fehlerbildes verwendet.

Mit bekannten Verfahren zur TE Messung ist eine derartige Identifizierung nicht möglich. das verbesserte Konzept erlaubt es also eine Bewertung der Teilentladung. Abhängig von der Bewertung kann beispielsweise eine Entscheidung getroffen werden, ob eine Handlung wie zum Beispiel eine Wartung, eine Reparatur, ein Stilllegen oder ein Austausch des Betriebsmittels oder eines Teils davon erforderlich ist. Insbesondere können nicht notwendige Handlungen vermieden werden.

Die Identifizierung kann insbesondere durch die Verteilung der Übertragungsparameter erfolgen. Das Fehlerbild kann gewissermaßen als "Fingerabdruck" der Fehlerquellen angesehen werden.

Gemäß wenigstens einer Ausführungsform wird das Fehlerbild einem bekannten charakteristischen Fehlerbild zugeordnet.

Das bekannte charakteristische Fehlerbild kann beispielsweise einem Fehlerkatalog entnommen oder durch maschinelles Lernen erzeugt werden.

Gemäß wenigstens einer Ausführungsform beinhaltet das Verfahren außerdem das Erzeugen eines Antwortsignals in Abhängigkeit von einem theoretischen Eingangssignal, welches insbesondere zeitdiskret ist, und den Übertragungsparametern.

Das Antwortsignal entspricht dabei einem theoretischen Messsignal, wenn am Ort der Teilentladung das theoretische Eingangssignal vorliegen würde.

Gemäß wenigstens einer Ausführungsform ist das theoretische Eingangssignal ein Pulssignal, welches einen Teilentladungsimpuls approximiert. Beispielsweise kann das theoretische Eingangssignal nur zu einem diskreten Zeitpunkt von Null verschieden sein. Dies entspricht der üblicherweise sehr kurzen Anstiegszeit eines Teilentladungsimpulses.

Gemäß wenigstens einer Ausführungsform beinhaltet das Erzeugen des Antwortsignals das Bestimmen einer Übertragungsfunktion aus den Übertragungsparametern und das Anwenden der Übertragungsfunktion auf das theoretische Eingangssignal.

Hierbei ist "Anwenden" im Sinne der Anwendung eines mathematischen Operators zu verstehen. Beispielsweise kann das Anwenden der Übertragungsfunktion auf das theoretische Eingangssignal in einem z-Raum erfolgen. Das heißt, eine z-Transformation des theoretischen Eingangssignals kann erzeugt und mit der Übertragungsfunktion in entsprechender z-Raum Darstellung multipliziert werden. Optional kann das Resultat durch eine inverse z-Transformation in den diskreten Zeitraum zurücktransformiert werden um das Antwortsignal im disl<reten Zeitraum zu erhalten. Alternativ kann die Berechnung im diskreten Zeitraum oder im Frequenzraum erfolgen.

Gemäß wenigstens einer Ausführungsform beinhaltet die wenigstens eine Kenngröße der Teilentladung einen Wert für eine scheinbare Ladung der Teilentladung. Insbesondere ist die scheinbare Ladung eine scheinbare Ladung am Ort der Teilentladung.

Gemäß wenigstens einer Ausführungsform wird der Wert für eine scheinbare Ladung der Teilentladung in Abhängigkeit von dem Antwortsignal bestimmt.

Gemäß wenigstens einer Ausführungsform beinhaltet das Bestimmen des Wertes für die scheinbare Ladung eine Integration des Antwortsignals oder eines von dem Antwortsignal abhängigen Signals, insbesondere im diskreten Zeitraum. Das von dem Antwortsignal abhängige Signal kann beispielsweise durch Filtern des Antwortsignals erzeugt werden. Das Filtern kann dabei einem Bandpassfiltern entsprechen, insbesondere mit einem Frequenzband gemäß dem internationalen Standard IEC 60270:2000, dessen Inhalt hiermit durch Bezugnahme hierin aufgenommen wird. Das Frequenzband kann beispielsweise innerhalb des Bereichs 100-900 kHz liegen oder beispielsweise 100-400 kHz entsprechen.

Dadurch, dass das Antwortsignal keinem wesentlichen Rauschen oder anderen Störeinflüssen unterliegt, kann trotz der Signaldämpfung ein zuverlässiger Wert für die scheinbare Ladung am Ort der TE bestimmt werden. Gemäß dem verbesserten Konzept kann die scheinbare Ladung also mit erhöhter Genauigkeit und unabhängig von der Entfernung der Anschlussstelle zum Ort der Teilentladung ermittelt werden.

Der so ermittelte Ladungswert kann in Bezug zum theoretischen Eingangssignal gesetzt werden. Daraus kann ermittelt werden welcher Anteil des Eingangssignals noch als Ausgangssignal gemessen werden kann. Dies ermöglicht die Bestimmung der am Entladungsort umgesetzten Energie unabhängig von der Entfernung des Messpunktes zum Fehlerort. Für die Zustandsbeurteilung an elektrischen Betriebsmitteln ist dies von erheblichem Vorteil, da somit die von der Fehlstelle ausgehende Gefährdung beurteilt werden kann.

Der Wert für die scheinbare Ladung am Ort der TE kann nach dem verbesserten Konzept sowohl für homogen aufgebaute als auch für inhomogen aufgebaute Betriebsmittel bestimmt werden.

Gemäß wenigstens einer Ausführungsform beinhaltet die wenigstens eine Kenngröße der Teilentladung einen Fehlerort der Teilentladung. Der Fehlerort der Teilentladung wird dabei in Abhängigkeit von dem Antwortsignal ermittelt.

Gemäß wenigstens einer Ausführungsform beinhaltet das Ermitteln des Fehlerortes der Teilentladung eine Anpassung einer Referenzfunktion an das Antwortsignal, wobei die Anpassung durch eine Anpassung wenigstens eines Parameters der Referenzfunktion erfolgt.

Gemäß wenigstens einer Ausführungsform erfolgt die Anpassung unter Verwendung eines numerischen Optimierungsalgorithmus, beispielsweise eines Levenberg-Marquardt-Algorithmus.

Gemäß wenigstens einer Ausführungsform handelt es sich bei der Referenzfunktion um eine Lösung einer Differenzialgleichung zur Beschreibung eines elektrischen Schwingkreises. Dies liegt darin begründet, dass die Teilentladung einen elektrischen Schwingkreis zwischen Fehlerort der Teilentladung und Anschlussstelle anregt.

Gemäß wenigstens einer Ausführungsform erfolgt die Bestimmung des Fehlerortes in Abhängigkeit einer Kapazität und/oder einer Induktivität des Betriebsmittels, wobei die Kapazität und/oder die Induktivität insbesondere einen jeweiligen Näherungswert darstellen.

Gemäß wenigstens einer Ausführungsform werden die Kapazität und/oder die Induktivität durch die Anpassung der Referenzfunktion an das Antwortsignal ermittelt. Insbesondere handelt es sich bei der Kapazität und/oder die Induktivität um Parameter der Referenzfunktion, welche angepasst werden.

Gemäß wenigstens einer Ausführungsform wird aus dem wenigstens einen angepassten Parameter der Referenzfunktion und einer Geometrie des Betriebsmittels der Ort der Teilentladung bestimmt.

Der Ort der Teilentladung lässt sich nach dem verbesserten Konzept insbesondere für homogen aufgebaute Betriebsmittel bestimmen. Dadurch, dass das Antwortsignal keinem wesentlichen Rauschen oder anderen Störeinflüssen unterliegt, kann trotz der Signaldämpfung eine sehr genaue Ortung der Fehlerquelle erzielt werden, unabhängig von der Entfernung der Anschlussstelle zum Fehlerort. Tests lassen eine Genauigkeit von mindestens 5% bezogen auf eine Länge des Betriebsmittels erwarten.

Für inhomogen aufgebaute Betriebsmittel lassen sich wenigstens die Parameter der Referenzfunktion ermitteln, insbesondere die Kapazität und/oder die Induktivität, wodurch auch ohne detaillierte Einbeziehung der Geometrie des Betriebsmittels eine qualitative Bewertung erfolgen kann, beispielsweise eine relative Position verschiedener Fehlerquellen zueinander und bezogen auf die Anschlussstelle ermittelt werden kann.

Gemäß dem verbesserten Konzept wird auch eine Prüfvorrichtung zur Zustandsanalyse eines elektrischen Betriebsmittels angegeben. Die Prüfvorrichtung weist eine Auswerteeinrichtung auf, die dazu eingerichtet ist, ein Messsignal an einer Anschlussstelle des Betriebsmittels zu erfassen. Die Auswerteeinheit ist ferner dazu eingerichtet abhängig von dem Messsignal Übertragungsparameter zu ermitteln, welche eine Signalübertragung von einem Ort einer Teilentladung in dem Betriebsmittel zu der Anschlussstelle charakterisieren. Außerdem ist die Auswerteeinheit dazu eingerichtet, wenigstens eine Kenngröße der Teilentladung abhängig von den Übertragungsparametern zu bestimmen.

Gemäß wenigstens einer Ausführungsform der Prüfvorrichtung beinhaltet diese auch eine Hochspannungsquelle zum Anlegen einer Prüfspannung an das Betriebsmittel.

Gemäß wenigstens einer Ausführungsform beinhaltet die Prüfvorrichtung eine Koppeleinheit, die mit der Anschlussstelle und mit der Auswerteeinheit koppelbar, insbesondere direkt oder indirekt elektrisch verbindbar, und dazu eingerichtet ist, der Auswerteeinheit das Messsignal bereitzustellen.

Gemäß wenigstens einer Ausführungsform beinhaltet die Koppeleinheit eine Messimpedanz, insbesondere ein induktives Element mit einstellbarer Induktivität.

Gemäß wenigstens einer Ausführungsform beinhaltet die Koppeleinheit ein dem induktiven Element nachgeschaltetes Filterelement oder Filternetzwerk. Das Filterelement weist dabei beispielsweise Hochpass- oder Bandpasscharakteristik auf.

Mögliche Grenzfrequenzen für den Hochpass können beispielsweise 30 kHz oder 100 kHz sein. Für den Bandpass wiederum sind beispielsweise 100 kHz als untere Grenzfrequenz und/oder 400 kHz oder 500 kHz als obere Grenzfrequenz möglich. Andere Grenzfrequenzen sind entsprechend den konkreten Anforderungen möglich oder erforderlich. Für Monitoring Anwendungen können beispielsweise Bandpasscharakteristika erforderlich sein, die eine obere Grenzfrequenz von mehreren MHz bis hin zu mehreren 10 MHz erfordern.

Gemäß wenigstens einer Ausführungsform ist die Koppeleinheit dazu eingerichtet ein Signal, insbesondere ein Stromsignal, an ihrem Eingang in das Messsignal, insbesondere ein Spannungssignal, an ihrem Signalausgang umzuwandeln.

Gemäß wenigstens einer Ausführungsform beinhaltet die Prüfvorrichtung einen Koppelkondensator, der zwischen die Koppeleinheit und die Anschlussstelle schaltbar, insbesondere mit der Anschlussstelle elektrisch direkt oder indirekt verbindbar und mit der Koppeleinheit elektrisch direkt oder indirekt verbindbar oder verbunden. Bei dem Koppelkondensator handelt es sich beispielsweise um einen Hochspannungskondensator. Der Koppelkondensator kann beispielsweise für das Nachladen einer Fehlerquelle beziehungsweise eine Aufrechterhaltung eines elektrischen Feldes an der Fehlstelle sorgen.

Weitere Ausgestaltungsformen und Implementierungen der Prüfvorrichtung ergeben sich unmittelbar aus den

**EP 3 870 983 B1**

verschiedenen Ausgestaltungsformen des Verfahrens nach dem verbesserten Konzept und umgekehrt. Insbesondere können einzelne oder mehrere der bezüglich der Prüfvorrichtung beschriebenen Komponenten und/oder Anordnungen zur Durchführung des Verfahrens entsprechend implementiert sein.

Im Folgenden wird die Erfindung anhand beispielhafter Ausführungsformen unter Bezug auf die Zeichnungen im Detail erklärt. Komponenten, die identisch oder funktionell identisch sind oder einen identischen Effekt haben, können mit identischen Bezugszeichen versehen sein. Identische Komponenten oder Komponenten mit identischer Funktion sind unter Umständen nur bezüglich der Figur erklärt, in der sie zuerst erscheinen. Die Erklärung wird nicht notwendigerweise in den darauffolgenden Figuren wiederholt.

Es zeigen

Figur 1          eine schematische Darstellung einer beispielhaften Ausführungsform einer Prüfvorrichtung gemäß dem verbesserten Konzept und eines beispielhaften Betriebsmittels;

Figuren 2a, 2b   Darstellungen einer beispielhaften Übertragungsfunktion gemäß einer beispielhaften Ausführungsform eines Verfahrens nach dem verbesserten Konzept;

Figuren 3a, 3b, 3c   Darstellungen eines Messsignals, eines theoretischen Eingangssignals und eines Antwortsignals gemäß einer weiteren beispielhaften Ausführungsform eines Verfahrens nach dem verbesserten Konzept; und

Figur 4          Darstellungen einer Referenzfunktion und eines Antwortsignals gemäß einer weiteren beispielhaften Ausführungsform eines Verfahrens nach dem verbesserten Konzept.

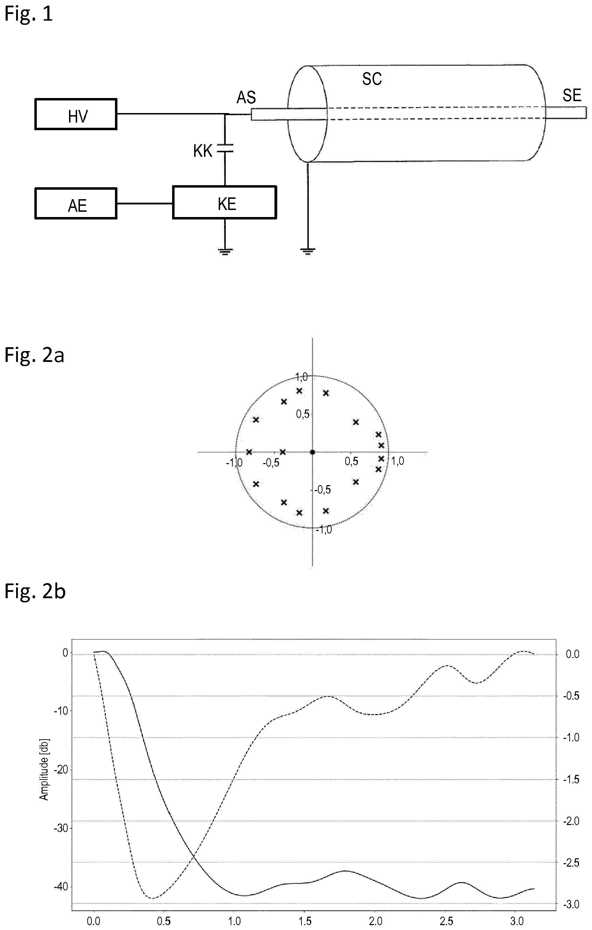

Figur 1 zeigt eine schematische Darstellung einer beispielhaften Ausführungsform einer Prüfvorrichtung gemäß dem verbesserten Konzept und eines beispielhaften Betriebsmittels. Das Betriebsmittel ist beispielhaft als geschirmtes Kabel mit einem Schirm SC und einer Seele SE dargestellt. Das Betriebsmittel kann jedoch ein beliebiges, homogen oder inhomogen aufgebautes elektrisches Betriebsmittel mit voneinander elektrisch isolierten Komponenten sein.

Seele SE und Schirm SC sind entsprechend durch die voneinander elektrisch isolierten Komponenten des Betriebsmittels zu ersetzen. Bei GIS oder GIL wären das beispielsweise einer der isolierten Leiter und ein Druckgefäß der GIS/GIL. Bei Transformatoren wären das beispielsweise eine Transformatorwicklung und ein Kessel des Transformators. Prinzipiell ist eine Auskopplung immer möglich, sofern eine entsprechende Kapazität vorliegt, um wenigstens einen Teil der TE nachladen und somit erfassen zu können.

Die Prüfvorrichtung kann eine Hochspannungsquelle HV, beispielsweise einen Hochspannungsgenerator, aufweisen, der an einer Anschlussstelle AS des Betriebsmittels, beispielsweise der Seele SE, angeschlossen werden kann. Die Prüfvorrichtung kann außerdem einen Koppelkondensator KK und eine Koppeleinheit KE aufweisen, welche in Reihe zueinander geschaltet sind. Der Koppelkondensator KK ist beispielsweise an die Anschlussstelle AS anschließbar. Alternativ können Hochspannungsquelle HV und Koppelkondensator KK an unterschiedlichen Stellen des Betriebsmittels anschließbar sein, insbesondere die Hochspannungsquelle HV an einer Einprägestelle des Betriebsmittels, insbesondere der Seele SE, und der Koppelkondensator KK an der Anschlussstelle AS.

Alternativ kann es sich bei der Hochspannungsquelle auch um eine zur Energieerzeugung oder -verteilung ohnehin benötigte Komponente wie etwa einen Generator oder einen Netztransformator handeln.

Gemäß dem verbesserten Konzept weist die Prüfvorrichtung eine Auswerteeinheit AE auf, welche beispielsweise mit der Koppeleinheit KE elektrisch verbunden ist.

Bei einer Prüfung kann eine durch die Hochspannungsquelle HV bereitgestellte Prüfspannung an der Anschlussstelle AS in das Betriebsmittel eingeprägt werden. Daraufhin kann ein Signal, dass beispielsweise durch eine Teilentladung in einer Isolierung des Betriebsmittels erzeugt wird, über den Koppelkondensator KK und die Koppeleinheit KE erfasst und als Messsignal an die Auswerteeinheit AE ausgegeben werden.

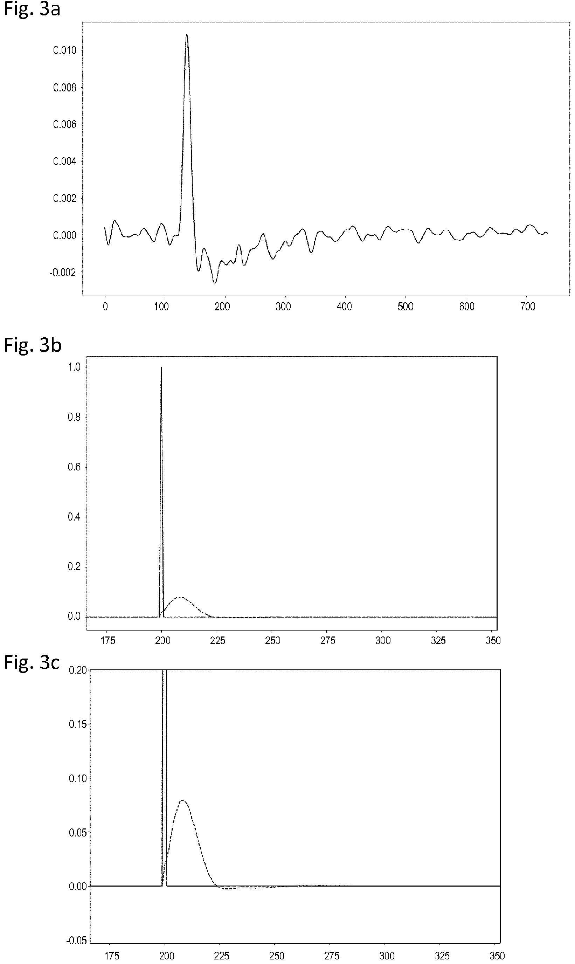

Die Auswerteeinheit AE kann beispielsweise das Messsignal digitalisieren und dadurch ein diskretes Messsignal erzeugen. Ein beispielhaftes diskretes Messsignal ist in Figur 3a gezeigt.

Die Auswerteeinheit AE kann dann anhand des Messsignals, insbesondere des diskreten Messsignals, Übertragungsparameter, welche eine Signalübertragung von einem Ort der Teilentladung in dem Betriebsmittel zu der Anschlussstelle AE charakterisieren, ermitteln und eine oder mehrere Kenngrößen der Teilentladung abhängig von den Übertragungsparametern bestimmen.

Die Übertragungsparameter können dabei die Prädiktoren $a_i$ eines durch die Rekursionsgleichung (1) definierten virtuellen Filters sein. Die Auswerteeinheit AE kann die Übertragungsparameter daher durch Minimierung des gesamten quadratischen Fehlers qE gemäß Gleichung (2) bestimmen.

Die Übertragungsparameter können als Parameter einer Übertragungsfunktion aufgefasst werden, welche ein theoretisches Eingangssignal durch die Teilentladung mit dem diskreten Messsignal verknüpft. Insbesondere können

6

die Übertragungsparameter Polstellen der Übertragungsfunktion im komplexen z-Raum entsprechen.

Figur 2a zeigt ein Ergebnis einer beispielhaften Bestimmung der Übertragungsparameter. Jedes Kreuz stellt dabei eine Polstelle der zugehörigen Übertragungsfunktion dar.

Figur 2b zeigt eine Amplitude (durchgezogene Linie) und einen Phasenwinkel (gestrichelte Linie) der Übertragungsfunktion aus Fig. 2a im Frequenzraum. Dazu kann die Übertragungsfunktion vom z-Raum durch inverse z-Transformation und Fourier-Transformation in den Frequenzraum transformiert werden.

Anhand der Übertragungsparameter und deren Verteilung, insbesondere Anhand der Anordnung der Polstellen der Übertragungsfunktion kann bereits direkt eine Charakterisierung der Fehlerquelle oder Fehlerquellen vorgenommen werden, welche die Teilentladung oder mehrere Teilentladungen verursacht haben. Beispielsweise kann anhand der Übertragungsparameter gewissermaßen ein Fingerabdruck der Fehlerquellen erzeugt werden und dieser beispielsweise mit bekannten charakteristischen Fehlerbildern verglichen werden. Insbesondere kann die Anzahl der Fehlerquellen und deren relativer Beitrag zur gesamten Teilentladung auf diese Weise bestimmt werden.

Figur 3b zeigt ein theoretisches, insbesondere digital erzeugtes Eingangssignal (durchgezogene Linie). Da ein Teilentladungsimpuls eine sehr schnelle Anstiegszeit aufweist, beispielsweise im Bereich weniger Nanosekunden oder einer Nanosekunde, kann das theoretische Eingangssignal beispielsweise einem digitalen Puls minimaler Breite entsprechen. Eine Fläche des theoretischen Eingangssignals beispielsweise gleich 1.

Figur 3b zeigt außerdem ein Antwortsignal (gestrichelte Linie), welches der Abbildung des theoretischen Eingangssignals mittels der Übertragungsfunktion entspricht. Figur 3c zeigt einen reduzierten Ausschnitt aus Figur 3b.

Das Antwortsignal ähnelt dem diskreten Messsignal aus Figur 3a, ist jedoch nahezu rauschfrei. Die Auswerteinheit AE kann das Antwortsignal beispielsweise in einem bestimmten, beispielsweise in IEC 60270:2000 angegebenen, Bereich, zum Beispiel im Bereich 100 - 400 kHz, filtern und integrieren. Das Ergebnis der Integration ist ein Maß für die scheinbare Ladung der Teilentladung am Ort der TE. Im Beispiel der Figuren 3b und 3c hat das digitale Eingangssignal die Fläche 1 und die Integration des gefilterten Antwortsignals ergibt beispielsweise 0,55. Vergleicht man diesen Wert mit einem Referenzwert, der beispielsweise durch Einspeisung einer definierten Ladung mit einem TE-Kalibrator bestimmt werden kann, lässt sich ein Wert für die scheinbare Ladung bestimmen.

Durch die Teilentladung kann ein Schwingkreis von Fehlerort zur Anschlussstelle AS angeregt werden. Die Schwingung kann allgemein beispielsweise durch die Differenzialgleichung

$$LC \cdot \ddot{U} + RC \cdot \dot{U} + U = 0 \, , \qquad\qquad (3)$$

beschrieben werden. Dabei ist U eine elektrische Spannung, R ein Widerstand, L eine Induktivität und C eine Kapazität in dem Schwingkreis. Eine Differenzialgleichung für einen entsprechenden elektrischen Strom hat dieselbe Form und kann analog verwendet werden.

Lösungen der Gleichung (3) können dann als Referenzfunktion dienen und haben im Schwingfall die bekannte Form

$$U(t) = U_0 \exp(-tR/2L) \cdot \sin\left(t/LC + \phi\right) \quad \text{falls } (R/2L)^2 < 1/LC \, . \qquad\qquad (4)$$

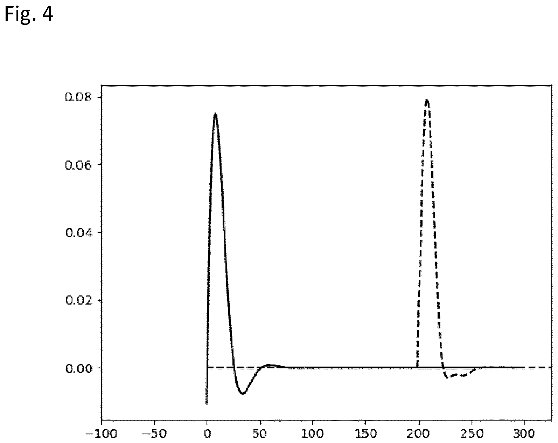

Dabei sind $U_0$ und $\phi$ von den Anfangsbedingungen der Schwingung abhängige Parameter. Für den Kriechfall und den aperiodischen Grenzfall sind entsprechende Lösungen der Gleichung (3) bekannt. Aus einer Anpassung beziehungsweise einem Fit der Referenzfunktion an das Antwortsignal kann insbesondere die Kapazität C oder die Induktivität L bestimmt werden. Figur 4 zeigt beispielhaft das Antwortsignal (gestrichelt) und die Referenzfunktion (durchgezogene Linie). Zur übersichtlicheren Darstellung sind die beiden Kurven zeitlich zueinander verschoben dargestellt.

Im Falle eines homogen aufgebauten Betriebsmittels, beispielsweise eines Kabels, einer GIS oder GIL, kann anhand der Geometrie des Betriebsmittels, beispielsweise Länge, Querschnitt des Kabels, Querschnitt der Seele, und gegebenenfalls anhand der verwendeten Isoliermaterialien, ein Abstand des Fehlerorts von der Anschlussstelle AS ermittelt werden. Damit lässt sich also der Fehlerort bestimmen.

Bei einem inhomogen aufgebauten Betriebsmittel kann basierend auf Induktivität L und/oder Kapazität C eine qualitative Charakterisierung der Fehlerquelle oder mehrerer Fehlerquellen erfolgen. Beispielsweise können relative Abstände zwischen Fehlerorten verschiedener Fehlerquellen und Anschlussstelle AS bestimmt oder eingegrenzt werden.

Mit einem Verfahren oder einer Prüfvorrichtung gemäß dem verbesserten Konzept wird eine genauere TE Analyse elektrischer Betriebsmittel ermöglicht. Die umgesetzte Ladung am Fehlerort kann bei allen Arten von elektrischen Betriebsmitteln, insbesondere bei Kabeln, ermittelt werden, was eine erhebliche Verbesserung der Zustandsbeurteilung erlaubt. Bei einem Verfahren nach dem verbesserten Konzept wird nur eine einzige Anregung benötigt, beispielsweise ein TE-Impuls am Fehlerort. Dadurch wird ein Schwingkreis aus induktiven, kapazitiven und resistiven Elementen des Betriebsmittels und des Messkreises aufgebaut. Der Strom beziehungsweise die Spannung in diesem Kreis ist vollständig beschrieben. Daher kann der Fehlerort, insbesondere bei Kabeln, auch bestimmt werden, ohne dass eine Signalreflektion am Fehlerort stattfindet. Fehler können daher auch bei geringen Teilentladungspegeln, also geringen umgesetzten Ladungen, und damit besonders frühzeitig erkannt werden. Zudem erlaubt das verbesserte Konzept eine Separation verschiedener Teilentladungsquellen anhand der ermittelten Übertragungsparameter ("Fingerabdruck").

Das verbesserte Konzept nutzt die Erkenntnis, dass das Betriebsmittel als Filter, beispielsweise als Tiefpass, angesehen werden kann. Ein Verfahren zum LPC kann daher eingesetzt werden um die Übertragungsparameter zu ermitteln. Die Genauigkeit der Übertragungsparameter hängt dabei insbesondere von der Ordnung der involvierten Näherung ab, sowie von den zur Verfügung stehenden Daten, beispielsweise von einer Abtastrate oder einem Signal-Rausch-Verhältnis des diskreten Messsignals.

Ein Verfahren nach dem verbesserten Konzept kann auch zur Zustandsbeurteilung von Komponenten der elektrischen Energieübertragung verwendet werden, beispielsweise im Sinne einer dauerhaften oder kontinuierlichen Überwachung während des Normalbetriebs der Komponenten (Monitoring).

Bezugszeichen

| HV | Hochspannungsquelle |
|---|---|
| AE | Auswerteeinheit |
| KK | Koppelkondensator |
| KE | Koppeleinheit |
| AS | Anschlussstelle |
| SC | Schirm |
| SE | Seele |

**Patentansprüche**

1.  Verfahren zur Zustandsanalyse eines elektrischen Betriebsmittels, wobei das Verfahren beinhaltet

    - Anlegen einer Prüfspannung an das Betriebsmittel;
    - Erfassen eines Messsignals an einer Anschlussstelle (AS) des Betriebsmittels;
    - Ermitteln von Übertragungsparametern, welche eine Signalübertragung von einem Ort einer Teilentladung in dem Betriebsmittel zu der Anschlussstelle (AS) charakterisieren, abhängig von dem Messsignal;
    - Bestimmen wenigstens einer Kenngröße der Teilentladung abhängig von den Übertragungsparametern;

    wobei

    - das Ermitteln der Übertragungsparameter eine Verarbeitung des Messsignals gemäß einem Verfahren zur linearen prädiktiven Kodierung beinhaltet.

2.  Verfahren nach Anspruch 1, wobei das Ermitteln der Übertragungsparameter das Ermitteln von Filterkoeffizienten eines virtuellen Filters beinhaltet, wobei das Filter die Signalübertragung näherungsweise nachbildet.

3.  Verfahren nach einem der Ansprüche 1 oder 2, wobei das Ermitteln der Übertragungsparameter eine Diskretisierung und/oder Digitalisierung des Messsignals beinhaltet.

4.  Verfahren nach einem der Ansprüche 1 bis 3, wobei die wenigstens eine Kenngröße der Teilentladung wenigstens eine Kenngröße einer oder mehrerer Fehlerquellen beinhaltet, aus denen die Teilentladung resultiert.

5.  Verfahren nach Anspruch 4, wobei die wenigstens eine Kenngröße der einen oder mehreren Fehlerquellen eine Anzahl der Fehlerquellen oder einen relativen Beitrag einer der Fehlerquellen zu der Teilentladung beinhaltet.

6.  Verfahren nach einem der Ansprüche 1 bis 5, wobei das Verfahren außerdem das Erzeugen eines Antwortsignals in Abhängigkeit von einem theoretischen Eingangssignal und den Übertragungsparametern beinhaltet.

7.  Verfahren nach Anspruch 6, wobei die wenigstens eine Kenngröße der Teilentladung einen Wert für eine scheinbare Ladung der Teilentladung beinhaltet.

8. Verfahren nach einem der Ansprüche 6 oder 7, wobei die wenigstens eine Kenngröße der Teilentladung einen Fehlerort der Teilentladung beinhaltet.

9. Verfahren nach Anspruch 8, wobei das Bestimmen des Fehlerortes in Abhängigkeit einer Kapazität und/oder einer Induktivität des Betriebsmittels erfolgt.

10. Verfahren nach einem der Ansprüche 1 bis 9, wobei das Betriebsmittel

- ein Kabel, insbesondere ein geschirmtes Kabel, beispielsweise ein Hochspannungskabel;
- eine gasisolierte Schaltanlage, GIS;
- eine gasisolierte Leitung, GIL;
- einen Leistungstransformator; oder
- einen Stufenschalter oder eine andere Komponente eines Leistungstransformators beinhaltet.

11. Prüfvorrichtung zur Zustandsanalyse eines elektrischen Betriebsmittels, die Prüfvorrichtung beinhaltend eine Auswerteeinrichtung (AE), die dazu eingerichtet ist

- ein Messsignal an einer Anschlussstelle (AS) des Betriebsmittels zu erfassen;
- abhängig von dem Messsignal Übertragungsparameter zu ermitteln, welche eine Signalübertragung von einem Ort einer Teilentladung in dem Betriebsmittel zu der Anschlussstelle (AS) charakterisieren; und
- wenigstens eine Kenngröße der Teilentladung abhängig von den Übertragungsparametern zu bestimmen;

wobei

- das Ermitteln der Übertragungsparameter eine Verarbeitung des Messsignals gemäß einem Verfahren zur linearen prädiktiven Kodierung beinhaltet.

12. Prüfvorrichtung nach Anspruch 11, außerdem beinhaltend eine Hochspannungsquelle (HV) zum Anlegen einer Prüfspannung an das Betriebsmittel.

13. Prüfvorrichtung nach einem der Ansprüche 11 oder 12, außerdem beinhaltend eine Koppeleinheit (KE), die mit der Anschlussstelle (AS) und mit der Auswerteeinheit (AE) koppelbar und dazu eingerichtet ist, der Auswerteeinheit (AE) das Messsignal bereitzustellen.

14. Prüfvorrichtung nach einem der Ansprüche 11 bis 13, außerdem umfassend einen Koppelkondensator (KK), der zwischen die Koppeleinheit (KE) und die Anschlussstelle (AS) schaltbar ist.

**Claims**

1. A method for analyzing the state of an electrical operating resource, wherein the method includes

- applying a test voltage to the operating resource;
- acquiring a measurement signal at a connection point (AS) of the operating resource;
- ascertaining transfer parameters that characterize a signal transmission from a location of a partial discharge in the operating resource to the connection point (AS), depending on the measurement signal;
- determining at least one characteristic variable of the partial discharge depending on the transfer parameters;

wherein

- the ascertainment of the transfer parameters contains a processing of the measurement signal in accordance with a method for linear predictive coding.

2. The method as claimed in claims 1, wherein the ascertainment of the transfer parameters contains the ascertainment of filter coefficients of a virtual filter, wherein the filter approximately simulates the signal transfer.

3. The method as claimed in one of claims 1 or 2, wherein the ascertainment of the transfer parameters contains a discretization and/or digitization of the measurement signal.

4. The method as claimed in one of claims 1 to 3, wherein the at least one characteristic variable of the partial discharge contains at least one characteristic variable of one or a plurality of fault sources from which the partial discharge results.

5. The method as claimed in claim 4, wherein the at least one characteristic variable of one or a plurality of fault sources contains a number of the fault sources or a relative contribution of one of the fault sources to the partial discharge.

6. The method as claimed in one of claims 1 to 5, wherein the method also contains the generation of a response signal depending on a theoretical input signal and the transfer parameters.

7. The method as claimed in claim 6, wherein the at least one characteristic variable of the partial discharge contains a value for an apparent charge of the partial discharge.

8. The method as claimed in one of claims 6 or 7, wherein the at least one characteristic variable of the partial discharge contains a fault location of the partial discharge.

9. The method as claimed in claim 8, wherein the determination of the fault location takes place depending on a capacitance and/or an inductance of the operating resource.

10. The method as claimed in one of claims 1 to 9, wherein the operating resource contains

- a cable, in particular a screened cable, for example a high-voltage cable;
- a gas-insulated switchgear, GIS;
- a gas-insulated cable, GIL;
- a power transformer; or
- a tap changer or another component of a power transformer.

11. A test apparatus for analyzing the state of an electrical operating resource, the test apparatus containing an evaluation device (AE) that is designed to

- acquire a measurement signal at a connection point (AS) of the operating resource;
- depending on the measurement signal, ascertain transfer parameters that characterize a signal transmission from a location of a partial discharge in the operating resource to the connection point (AS); and
- determine at least one characteristic variable of the partial discharge depending on the transfer parameters;

wherein

- the ascertainment of the transfer parameters contains a processing of the measurement signal in accordance with a method for linear predictive coding.

12. The test apparatus as claimed in claim 11, furthermore containing a high-voltage source (HV) for applying a test voltage to the operating resource.

13. The test apparatus as claimed in one of claims 11 or 12, furthermore containing a coupling unit (KE) that can be coupled to the connection point (AS) and to the evaluation unit (AE), and that is designed to provide the measurement signal to the evaluation unit (AE).

14. The test device as claimed in one of claims 11 to 13, furthermore comprising a coupling capacitor (KK) that can be connected between the coupling unit (KE) and the connection point (AS).

**Revendications**

1. Procédé d'analyse d'état d'un matériel électrique, dans lequel le procédé comprend

- l'application d'une tension de test au matériel ;
- la détection d'un signal de mesure au niveau d'un point de raccordement (AS) du matériel ;
- la détermination, en fonction du signal de mesure, de paramètres de transmission qui caractérisent une transmission de signal d'un lieu de décharge partielle dans le matériel jusqu'au point de raccordement (AS) ;
- la détermination d'au moins une caractéristique de la décharge partielle en fonction des paramètres de transmission ;

dans lequel

- la détermination des paramètres de transmission comprend un traitement du signal de mesure selon un procédé de codage prédictif linéaire.

2. Procédé selon la revendication 1, dans lequel la détermination des paramètres de transmission comprend la détermination de coefficients de filtrage d'un filtre virtuel, dans lequel le filtre reproduit approximativement la transmission du signal.

3. Procédé selon l'une quelconque des revendications 1 ou 2, dans lequel la détermination des paramètres de transmission comprend une discrétisation et/ou une numérisation du signal de mesure.

4. Procédé selon l'une quelconque des revendications 1 à 3, dans lequel ladite au moins une caractéristique de la décharge partielle comprend au moins une caractéristique d'une ou de plusieurs sources de défaut dont résulte la décharge partielle.

5. Procédé selon la revendication 4, dans lequel ladite au moins une caractéristique desdites une ou plusieurs sources de défaut comprend un nombre des sources de défaut ou une contribution relative de l'une des sources de défaut à la décharge partielle.

6. Procédé selon l'une quelconque des revendications 1 à 5, dans lequel le procédé comprend en outre la génération d'un signal de réponse en fonction d'un signal d'entrée théorique et des paramètres de transmission.

7. Procédé selon la revendication 6, dans lequel ladite au moins une caractéristique de la décharge partielle comprend une valeur d'une charge apparente de la décharge partielle.

8. Procédé selon l'une quelconque des revendications 6 ou 7, dans lequel ladite au moins une caractéristique de la décharge partielle comprend un lieu de défaut de la décharge partielle.

9. Procédé selon la revendication 8, dans lequel la détermination du lieu de défaut s'effectue en fonction d'une capacité et/ou d'une inductance du matériel.

10. Procédé selon l'une quelconque des revendications 1 à 9, dans lequel le matériel comprend

- un câble, en particulier un câble blindé, par exemple un câble à haute tension ;
- un tableau de distribution à isolation gazeuse, GIS ;
- une conduite à isolation gazeuse, GIL ;
- un transformateur de puissance ; dans lequel
- un changeur de prise ou un autre composant d'un transformateur de puissance.

11. Dispositif de test pour l'analyse d'état d'un matériel électrique, le dispositif de test comprenant un dispositif d'évaluation (AE), qui est conçu pour

- détecter un signal de mesure au niveau d'un point de raccordement (AS) du matériel ;
- déterminer, en fonction du signal de mesure, des paramètres de transmission qui caractérisent une transmission de signal d'un lieu de décharge partielle dans le matériel jusqu'au point de raccordement (AS) ; et
- déterminer au moins une caractéristique de la décharge partielle en fonction des paramètres de transmission ; dans lequel
- la détermination des paramètres de transmission comprend un traitement du signal de mesure selon un procédé de codage prédictif linéaire.

**12.** Dispositif de test selon la revendication 11, comprenant en outre une source de haute tension (HV) destinée à appliquer une tension de test au matériel.

**13.** Dispositif de test selon l'une quelconque des revendications 11 ou 12, comprenant en outre une unité de couplage (KE) qui peut être couplée au point de raccordement (AS) et à l'unité d'évaluation (AE) et qui est conçue pour fournir le signal de mesure à l'unité d'évaluation (AE).

**14.** Dispositif de test selon l'une quelconque des revendications 11 à 13, comprenant en outre un condensateur de couplage (KK) pouvant être connecté entre l'unité de couplage (KE) et le point de raccordement (AS) .

## Fig. 1

## Fig. 2a

## Fig. 2b

Fig. 3a

Fig. 3b

Fig. 3c

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102017116613 B3